# EUROPÄISCHE PATENTSCHRIFT

(11) **EP 0 501 231 B1**
(45) Veröffentlichungstag und Bekanntmachung des Hinweises auf die Patenterteilung: **02.11.1994**
(21) Anmeldenummer: 92102368.5
(22) Anmeldetag: 13.02.1992
(51) Int. Cl.: B30B 13/00

(54) **Verfahren zur Herstellung von Metallfolien sowie deren Verwendung**
Process for the production of metal foils and their use
Procédé pour la préparation de feuilles métalliques et leur utilisation

(30) Priorität: 26.02.1991 DE 4105910
(43) Veröffentlichungstag der Anmeldung: 02.09.1992
(73) Patentinhaber: BAYER AG, 51368 Leverkusen (DE)
(72) Erfinder: Knauth, Philippe, Dr., W-6600 Saarbrücken (DE); Lange, Horst, Dr., W-4630 Bochum (DE); Schwirtlich, Ingo, Dr., W-4150 Krefeld (DE); Wambach, Karsten, Dr., W-4030 Ratingen (DE)

(56) Entgegenhaltungen:
- US-A- 3 734 695
- US-A- 4 242 175
- US-A- 4 399 116

## Beschreibung

Die vorliegende Erfindung betrifft ein Verfahren zur Herstellung von Metallfolien hoher Reinheit, insbesondere von Silicium-Folien, und deren Verwendung.

Die Photovoltaik steht im Vergleich zu konventionellen Energielieferanten unter wirtschaftlichen Gesichtspunkten in einer schwierigen Konkurrenzsituation. Es ist dabei insbesondere aus umweltpolitischen Gründen das Ziel, Strom mittels der Photovoltaik konkurrenzfähig im Vergleich zu den bekannten Energieträgern herzustellen.

Solarzellen auf der Basis kristallinen Siliciums haben sich technisch in der Praxis bewährt. Es stehen relativ große Produktionsanlagen zur Verfügung, die das Kostensenkungspotential der Massenfertigung bereits weitgehend nutzen können. Zur Verbesserung der Konkurrenzfähigkeit sind jedoch weitere Maßnahmen erforderlich. Die Verbilligung der als Ausgangsmaterial dienenden Siliciumscheiben ist dabei ein bedeutender Punkt.

Eine deutliche Verbesserung der Kostensituation wird in der Ablösung der dem Stand der Technik entsprechenden Verfahrensweise über Blockguß mit anschließender mechanischer Zerteilung zu Scheiben durch schnelle Folienziehverfahren gesehen.

Bei schnellen Folienziehverfahren muß gewährleistet sein, daß die Ausbildung intrinsischer Gitterfehler bei der Kristallisation vermieden wird. Restverunreinigungen in der schmelzflüssigen Phase werden im allgemeinen direkt in die kristallisierende Folie eingebaut, da die Segregation in der Regel wegen der hohen Wachstumsgeschwindigkeit nicht genutzt werden kann. Zur Reinigung der Folien ist daher eine anschließende Behandlung erforderlich.

Es sind eine Vielzahl von Reinigungsverfahren für festes oder schmelzflüssiges Silicium aus der Literatur bekannt.

Zum Reinigen können die bekannten Zonenreinigungsverfahren verwendet werden. Außerdem wurde in der EP-A 125 630 vorgeschlagen, das Silicium mechanisch zu zerkleinern und chemisch, z.B. durch Säurelaugung, derart zu behandeln, daß die Verunreinigungen entfernt werden. Es gelingt jedoch mit dieser Methode nicht, die Restkonzentration an Metallen auf die gewünschten niedrigen Werte unterhalb 0,1 ppmg zu reduzieren.

Im US-Patent US-A 4 231 755 wird ein Verfahren beschrieben, bei dem ein Roller aus siliciumresistentem Material, dessen Temperatur unterhalb der Schmelztemperatur des Siliciums liegt, durch ein Bad mit dem verunreinigten schmelzflüssigen Silicium gedreht wird. Das an der Oberfläche des Rollers erstarrte Silicium wird in einem zweiten Schritt in eine Zone mit einer Temperatur oberhalb seiner Schmelztemperatur geführt, wieder aufgeschmolzen und aufgefangen. Die mit Verunreinigungen angereicherte Restschmelze wird von Zeit zu Zeit abgelassen.

Reinigungsverfahren von Siliciumschmelzen mit reaktiven Gasgemischen sind weiterhin aus der US-A 4 298 423 bekannt, nach der schmelzflüssiges Silicium mit nichtoxidierenden Gasen gereinigt wird, die aus Wasserstoff, Stickstoff, Argon, Helium, Neon oder Mischungen daraus bestehen, wobei Wasserstoff bevorzugt ist. Beim Verfahren gemäß der DE-A 3 504 723 wird Silicium im schmelzflüssigen Zustand durch Einblasen von Wasserstoff gereinigt.

Aus der US-A-4 242 175 geht ein Verfahren zur Herstellung von hochreinem Silicium hervor, wobei Silicium zunächst geschmolzen wird und in Form eines dünnen Films durch einen Reaktor laufen gelassen wird, das mit einer reaktiven Atmosphäre gefüllt ist. Im unteren Teil des Reaktors wird das flüssige Silicium aufgefangen und kristallisiert.

Gemäß EP-A 0 264 045 hat sich eine gleichzeitige Behandlung von Siliciumschmelzen mit gasförmigen Halogenverbindungen und Wasserdampf und/oder Wasserstoff bewährt. Die gasförmigen Halogenverbindungen können Halogensilane SiₙX₂ₙ₊₂ (n = 1-4, X = Halogen oder Wasserstoff), Siliciumtetrachlorid oder Chlorwasserstoff sein. Es ist vorteilhaft, den reaktiven Gasen ein Inertgas, beispielsweise Argon oder Helium, zuzusetzen.

In der EP-A 0 274 283 wird ein Verfahren zur Reinigung von zerkleinertem Silicium unter einem Plasma beschrieben, wobei das Silicium im ersten Schritt unter einem Plasma aus 1 bis 100 % Wasserstoff und 99 bis 0 % Argon geschmolzen und im zweiten Schritt das geschmolzene Silicium mit einem Plasma aus Argon, Sauerstoff und Wasserstoff behandelt wird, wobei zwischen 0,005 % und 0,05 % Sauerstoff und zwischen 1 % und 99,995 % Wasserstoff vorliegen.

Die vorgenannten Reinigungsverfahren erfordern mehrere zusätzliche kostenintensive Arbeitsschritte und sind auf bereits hergestellte Scheiben und Folien nicht anwendbar.

In der DE-A 3 712 443 wird die Reinigungswirkung einer Sauerstoffbehandlung auf nach dem WEB-Folienziehverfahren hergestellte Siliciumscheiben beschrieben. Dabei werden die Siliciumwafer nach dem Ziehprozeß einer separaten Hochtemperaturbehandlung in einer sauerstoffhaltigen Atmosphäre unterzogen. Das genannte Verfahren beinhaltet also einen zusätzlichen kostenintensiven Arbeitsschritt nach dem Folienziehprozeß. Eine Reinigung der Folien während ihrer Kristallisation, d.h. mit der Geschwindigkeit des Ziehprozesses, ist mit diesem Verfahren nicht durchführbar.

Aufgabe dieser Erfindung ist es somit, ein Verfahren zur Verfügung zu stellen, daß die Nachteile der beschriebenen Verfahren nicht aufweist.

Überraschenderweise wurde nun gefunden, daß es möglich ist, den Reinigungsschritt in den Herstellungsprozeß von Metallfolien, die durch gerichtete Erstarrung und eine reaktive Gasbehandlung erhalten werden, zu integrieren. Dies geschieht dadurch, daß das Metall während der Gasbehandlung in kristallisierender Form vorliegt.

Gegenstand dieser Erfindung ist somit ein Verfahren zur Herstellung von Metallfolien hoher Reinheit, welches dadurch gekennzeichnet ist, daß die Metallfolien im kristallisierenden Zustand im Bereich des 2-Phasengebietes zwischen der schmelzflüssigen und der festen Phase mit reaktiven Gasen behandelt werden.

Das Verfahren besteht in einer Kombination aus der Reinigungswirkung durch Segregation, d.h. der Anreicherung von Verunreinigungen in der schmelzflüssigen Phase während der Kristallisation und der Abreicherung der an die Oberfläche dieser flüssigen Phase gelangten Verunreinigungen über eine reaktive Gasbehandlung. Die dabei entstehenden flüchtigen Verbindungen von Verunreinigungen mit dem behandelnden Gas entweichen über die Gasphase, während die nichtflüchtigen Verunreinigungen und Verbindungen an der Oberfläche verbleiben.

Die Wirksamkeit des erfindungsgemäßen Verfahrens ist umso größer, je größer das Verhältnis aus der mit dem Gas beaufschlagten Oberfläche und dem Volumen des kristallisierenden Körpers ist.

Das bevorzugte Anwendungsgebiet dieses Prozesses liegt daher im Bereich von kristallisierenden Scheiben oder Bändern bzw. Folien, die ein besonders günstiges Oberflächen- zu Volumenverhältnis aufweisen, jedoch ist auch die Anwendung bei kristallisierenden Gußblöcken, deren schmelzflüssige Phase durch Nachchargierung aufgefüllt wird, in vorteilhafter Weise denkbar, wie sie beim Strangguß vorliegt.

Bei schnellen Folienziehprozessen ist eine Segregation der Restverunreinigungen in der Regel entweder nicht möglich oder unerwünscht, weil die segregierenden Fremdatome sich in der Restschmelze anreichern würden.

Eine Ausnahme bildet das in der EP-A 165 449 beanspruchte Verfahren, das bei einer niedrigen Kristallisationsgeschwindigkeit von wenigen Zentimetern pro Minute eine hohe Ziehgeschwindigkeit von mehreren Metern pro Minute aufweist. Die so hergestellten Folien sind besonders für das erfindungsgemäße Verfahren geeignet, ebenso die nach dem aus der EP-A 123 863 offenbarten Verfahren.

Eine kontinuierliche Kristallisation liegt vor, wenn Metallbänder erhalten werden, Bei der intermittierend kontinuierlichen Kristallisation werden getrennte Metallkörper erhalten.

Durch die niedrige Kristallisationsgeschwindigkeit ist eine Segregation von Restverunreinigungen möglich, die sich in einem dünnen Schmelzfilm anreichern, der erst erstarrt, wenn die Folie keinen Kontakt mehr mit der Vorratsschmelze hat. Dadurch wird eine Verunreinigung der Vorratsschmelze vermieden.

Eine Abreicherung dieser in der Oberflächenschicht aufkonzentrierten Verunreinigungen ist über die Behandlung mit reaktiven Gasen möglich. Dabei ist ein in Zusammenhang und Menge gleichmäßiges und homogenes Reaktionsgas an der Folienoberfläche erforderlich, Darüber hinaus muß gewährleistet sein, daß die flüchtigen Verunreinigungsverbindungen sofort nach ihrer Bildung aus der Reaktionszone entfernt werden.

Dazu wird das Reaktionsgas in gut gemischter und disperser Form mit der kristallisierenden Folie in Kontakt gebracht. Durch die Einstellung einer möglichst laminaren Strömung in Ziehrichtung der Folie wird sichergestellt, daß die Prozeßgase aus der Reaktionszone abgeführt werden.

Die endgültige Reinheit wird durch einen abschließenden Ätzschritt oder einen mechanischen Oberflächenabtrag erzielt.

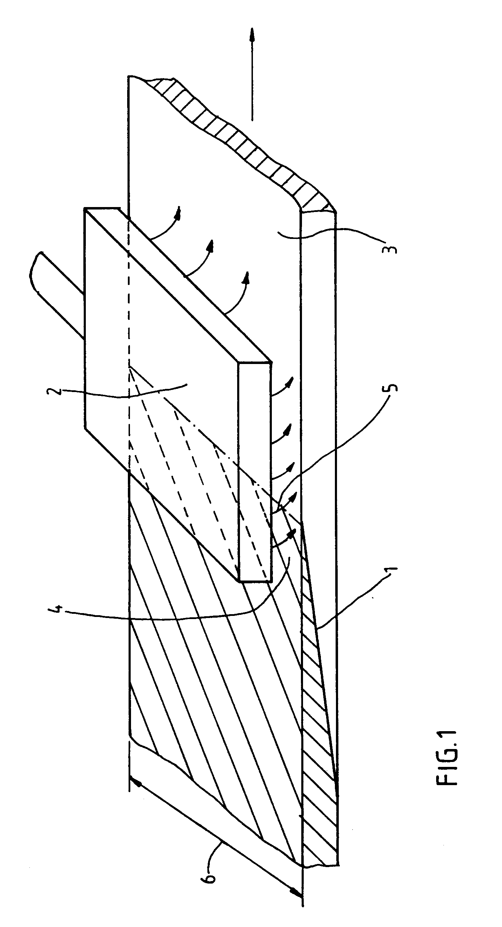

Eine mögliche Vorrichtung zur Durchführung des Verfahrens ist in Fig. 1 dargestellt. Sie besteht darin, daß im Bereich des Zweiphasengebietes (1) der kristallisierenden Folie eine Gasauslaßvorrichtung (2) angebracht wird, dergestalt, daß die austretende Metallfolie (3), an deren Oberseite eine gewisse Menge schmelzflüssigen Metalls (4) mitgeführt wird, mit dem reaktiven Gasgemisch (5) behandelt wird. Die Gaseinlaßvorrichtung (2) erstreckt sich über die ganze Breite (6) der Folie, wie Fig. 1 zu entnehmen ist.

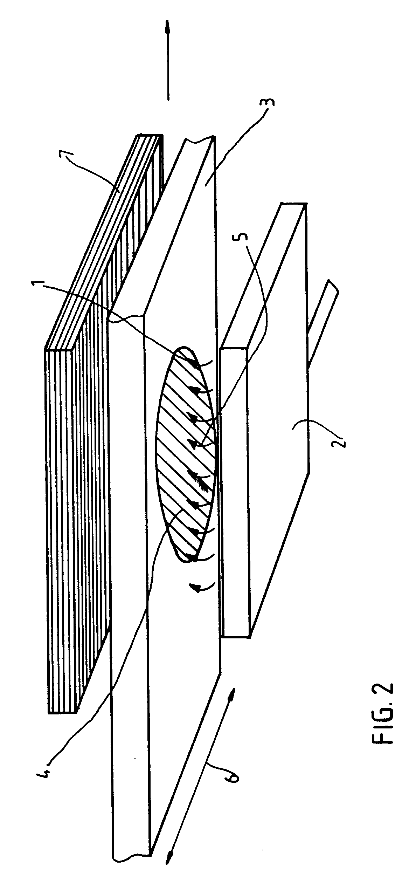

Günstige Ausführungsformen sind z.B. eine Fritte, eine Quarzfritte mit mehreren Kammern, oder eine Düse, die einen über die Breite (6) der Folie verlaufenden Spalt oder mehrere Spalten aufweist (Fig. 2). Das Gasgemisch kann zusätzlich vor dem Austreten aus der Gasauslaßvorrichtung (2) aufgeheizt oder gekühlt werden, um die mechanischen Eigenschaften des kristallisierenden Körpers zu beeinflussen, z.B. um das Auftreten thermischer Spannungen zu verhindern.

Das erfindungsgemäße Verfahren ist für die Reinigung unterschiedlicher Metallfolien geeignet. Aufgrund der Tatsache, daß beim Silicium die Erhöhung der Reinheit eine starke Verbesserung des technischen Wirkungsgrades mit sich bringt, ist das Verfahren insbesondere zur Reinigung von Siliciumfolien geeignet.

Als reaktive Gase können Sauerstoff, Wasserstoff, Wasserdampf oder Gemische aus Sauerstoff und Wasserdampf oder Wasserstoff und Wasserdampf sowie halogenhaltige Gase entsprechend der EP-A 264 045 eingesetzt werden. Inertgase im Sinne der Erfindung sind solche, die unter den Reaktionsbedingungen keine Reaktion eingehen. Als bevorzugte Inertgase seien Argon und Helium genannt. Die Gasgemische (5) bestehen dann aus mindestens 30 Vol.-% Argon und/oder Helium und bis zu 70 Vol.-% Sauerstoff trocken oder gesättigt mit Wasserdampf oder mindestens 70 Vol.-% Argon oder Helium und 1 bis 30 Vol.-% Wasserstoff mit Wasserdampf. Alternativ kann der Reinigungsprozeß auch in das Folienziehverfahren gemäß EP-A 123 863 integriert werden.

Die Anwendung des erfindungsgemäßen Verfahrens führt zu einer starken Abnahme der Kohlenstoffverunreinigungen in der Folie. Der Kohlenstoffgehalt der mit einem reaktiven Gasgemisch behandelten Siliciumfolien ist gegenüber den nur unter Inertgas gezogenen geringer. Eine Bor- und Phosphorabreicherung wird ebenfalls beobachtet. Die Abreicherung metallischer Verunreinigungen, wie Chrom, Titan, Calcium, Magnesium, Eisen, Molybdän, Nickel, Kupfer, wird durch einen zusätzlichen Ätzschritt begünstigt. Hierzu kommen anorganische Säuren, wie Flußsäure, Salzsäure, Schwefelsäure oder Mischungen daraus, oder Alkalilaugen, wie Natronlauge oder Kalilauge, zum Einsatz.

In einer bevorzugten Ausführungsform des erfindungsgemäßen Verfahrens werden also die Metallfolien anschließend mit anorganischen Säuren, wie z.B. Flußsäure, Salzsäure, Schwefelsäure oder Mischungen davon, oder mit Laugen, wie z.B. NaOH oder KOH, behandelt.

Die an der Oberfläche der Metallfolien angereicherten Verunreinigungen können auch durch mechanisches Abtrennen oder durch eine chemische Behandlung mit anorganischen Säuren und Laugen entfernt werden. Besonders gute Ergebnisse werden erzielt, wenn die Oberseite der Metallfolien bis zu einer Tiefe von 5 µm bis 60 µm, vorzugsweise 20 µm, mechanisch abgetragen wird.

Gegenstand dieser Erfindung ist auch die Verwendung der erfindungsgemäß hergestellten Silicium-Folien als Ausgangsmaterial für Solarzellen.

Die folgenden Beispiele sollen das erfindungsgemäße Verfahren an der Kristallisation von Folien verdeutlichen, wobei als Metall Silicium verwendet wird, ohne eine Einschränkung des Erfindungsgedankens darzustellen.

### Beispiele

### Beispiel 1

Bei der Kristallisation von Folien nach dem in der EP-A 165 449 beschriebenen Verfahren wird reaktives Gasgemisch, bestehend aus 20 Vol.-% Sauerstoff und 80 Vol.-% Argon verwendet. Das Gas wird über eine Quarzfritte eingeleitet, die im Bereich der Fest-Flüssig-Phasengrenze ca. einen Zentimeter über dem Substrat angebracht ist. Die Fritte erstreckt sich über die ganze Breite der Siliciumfolie und ist 10 cm breit und 2 cm lang. Die Durchflußgeschwindigkeit des Gasgemisches beträgt etwa 5 m³ pro Stunde, der Inertgasdruck in der Anlage vor Beginn der Einleitung des reaktiven Gases liegt bei 800 mbar. Durch das schmelzflüssige Silicium an der Folienoberfläche ist die Temperatur im Bereich der Begasung nahe der Temperatur des Zweiphasengleichgewichtes zwischen flüssigem und festem Silicium, also etwa 1.410°C. Nach dem Erkalten werden die Siliciumfolien zur Reinigung der Oberfläche 10 Minuten mit Natronlauge (20 %) bei 70°C behandelt. Die Reinigungswirkung der reaktiven Gasbehandlung ist aus der Tabelle zu ersehen, in der die Analysendaten der einzelnen Verunreinigungselemente in ppmg (Gewichts-ppm) für zwei verschiedene reaktive Prozeßgase im Vergleich zu einer Kristallisation unter Argon als Inertgas zu sehen sind (s. Tabelle, Zeile a). Die Folien wurden anschließend jeweils der obengenannten Natronlaugebehandlung unterzogen. Die Analysendaten sind in der Tabelle, Zeile b, gegeben.

### Beispiel 2

Es wurde ein Gasgemisch aus 80 Vol.-% Argon und 20 Vol.-% Sauerstoff verwendet, das bei 100°C mit Wasserdampf gesättigt wurde. Das Gas wurde durch eine Quarzdüse mit einer schlitzförmigen Öffnung von (10^{.}0,02) cm² eingeleitet. Die Durchflußgeschwindigkeit des Gasgemisches betrug 1 m³ pro Stunde, Nach dem Erhalten wurden die Folien wie oben abgeätzt. Die Analysenergebnisse der mit reaktivem Gasgemisch behandelten Folienstücke ergeben sich aus der Tabelle in Zeile c. Es wird eine Reinigungswirkung beobachtet, die der in Beispiel 1 angegebenen vergleichbar ist.

**Tabelle**

| Vergleich der Analysendaten von Siliciumfolien, die unter Argon (a), unter Argon (80 %)/Sauerstoff (20 %) trocken (b) und unter Argon (80 %)/Sauerstoff (20 %) gesättigt mit Wasserdampf (c) hergestellt wurden (ppmg). | | | | | | | | | | | | |
|---|---|---|---|---|---|---|---|---|---|---|---|---|
| | Al | B | Ca | Cr | Cu | Fe | Mg | Mo | Ni | Ti | P | C |
| a | 0,7 | 0,5 | 0,3 | 0,5 | 0,5 | 1,0 | 0,2 | 1,0 | 0,6 | 0,3 | 0,3 | 300 |
| b | 0,1 | 0,2 | 0,1 | 0,1 | 0,1 | 0,5 | 0,1 | 0,1 | 0,1 | 0,1 | 0,2 | 35 |
| c | 0,4 | 0,1 | 0,1 | 0,1 | 0,1 | 0,3 | 0,3 | 0,1 | 0,3 | 0,1 | 0,2 | 20 |

## Patentansprüche

1. Verfahren zur Herstellung von Metallfolien hoher Reinheit, dadurch gekennzeichnet, daß die Metallfolien im kristallisierenden Zustand im Bereich des 2-Phasengebietes zwischen der schmelzflüssigen und der festen Phase mit reaktiven Gasen behandelt werden.

2. Verfahren gemäß Anspruch 1, dadurch gekennzeichnet, daß die Metallfolie eine Silicium-Folie ist.

3. Verfahren gemäß einem der Ansprüche 1 oder 2, dadurch gekennzeichnet, daß die reaktiven Gase Sauerstoff, Wasserdampf, Wasserstoff oder Gemische aus Sauerstoff und Wasserdampf oder Wasserstoff und Wasserdampf sowie halogenhaltige Gase sind.

4. Verfahren gemäß Anspruch 3, dadurch gekennzeichnet, daß als inerte Gase Argon und/oder Helium eingesetzt werden.

5. Verfahren gemäß Anspruch 3 und 4, dadurch gekennzeichnet, daß die Mischungen aus reaktiven und inerten Gasen bis zu 70 % aus Sauerstoff, Wasserdampf und mindestens 30 % aus Argon und/oder Helium oder bis zu 30 % aus Wasserstoff, Wasserdampf und mindestens 70 % aus Argon und/oder Helium bestehen.

6. Verfahren gemäß einem oder mehreren der Ansprüche 1 bis 5, dadurch gekennzeichnet, daß die Metallfolien anschließend mit anorganischen Säuren, wie z.B. Flußsäure, Salzsäure, Schwefelsäure oder Mischungen davon, oder mit Laugen, wie z.B. NaOH oder KOH, behandelt werden.

7. Verfahren gemäß einem oder mehreren der Ansprüche 1 bis 5, dadurch gekennzeichnet, daß die Oberseite der Metallfolien bis zu einer Tiefe von 5 µm bis 60 µm, vorzugsweise 20 µm, mechanisch abgetragen wird.

8. Verwendung der gemäß einem oder mehreren der Ansprüche 2 bis 7 erhaltenen Silicium-Folien als Ausgangsmaterial für Solarzellen.

## Claims

1. A process for the production of high-purity metal foils, characterized in that the metal foils are treated with reactive gases in the crystallizing state in the region of the two-phase zone between the molten phase and the solid phase.

2. A process as claimed in claim 1, characterized in that the metal foil is a silicon foil.

3. A process as claimed in claim 1 or 2, characterized in that the reactive gases are oxygen, steam, hydrogen or mixtures of oxygen and steam or hydrogen and steam and halogen-containing gases.

4. A process as claimed in claim 3, characterized in that argon and/or helium is/are used as the inert gas(es).

5. A process as claimed in claims 3 and 4, characterized in that up to 70% of the mixtures of reactive and inert gazes consist of oxygen, steam and at least 30% of argon and/or helium or up to 30% of the mixtures consist of hydrogen, steam and at least 70% of argon and/or helium.

6. A process as claimed in one or more of claims 1 to 5, characterized in that the metal foils are subsequently treated with inorganic acids, such as for example hydrofluoric acid, hydrochloric acid, sulfuric acid or mixtures thereof, or with alkali metal hydroxides, such as for example NaOH or KOH.

7. A process as claimed in one or more of claims 1 to 5, characterized in that the upper surface of the metal foils is mechanically eroded to a depth of 5 µm to 60 µm and preferably 20 µm.

8. The use of the silicon foils obtained by the process claimed in one or more of claims 2 to 7 as starting material for solar cells.

## Revendications

1. Procédé pour la préparation de feuilles métalliques de pureté élevée, caractérisé en ce qu'on traite avec des gaz réactifs les feuilles métalliques dans un état à cristalliser dans la région du domaine des deux phases entre la phase liquide en fusion et la phase solide.

2. Procédé selon la revendication 1, caractérisé en ce que la feuille métallique est une feuille métallique en silicium.

3. Procédé selon l'une quelconque des revendications 1 ou 2, caractérisé en ce que les gaz réactifs sont de l'oxygène, de la vapeur d'eau, de l'hydrogène ou des mélanges d'oxygène et de vapeur d'eau ou d'hydrogène et de vapeur d'eau ainsi que des gaz contenant des halogènes.

4. Procédé selon la revendication 3, caractérisé en ce qu'on utilise comme gaz inertes de l'argon et/ou de l'hélium.

5. Procédé selon les revendications 3 et 4, caractérisé en ce que les mélanges de gaz réactifs et inertes sont constitués jusqu'à 70 % d'oxygène, de vapeur d'eau et d'au moins 30 % d'argon et/ou d'hélium ou jusqu'à 30 % d'hydrogène, de vapeur d'eau et d'au moins 70 % d'argon et/ou d'hélium.

6. Procédé selon l'une quelconque des revendications 1 à 5, caractérisé en ce qu'on traite ensuite les feuilles métalliques avec des acides inorganiques comme par exemple l'acide fluorhydrique, l'acide chlorhydrique, l'acide sulfurique ou des mélanges de ceux-ci, ou avec des bases, comme par exemple NaOH ou KOH.

7. Procédé selon l'une quelconque des revendications 1 à 5, caractérisé en ce qu'on enlève mécaniquement le côté supérieur des feuilles métalliques jusqu'à une profondeur de 5 µm à 60 µm, de préférence de 20 µm.

8. Utilisation des feuilles métalliques en silicium obtenues selon l'une quelconque des revendications 2 à 7 en tant que matière première pour des cellules solaires.
